# EUROPEAN PATENT APPLICATION

(11) **EP 1 087 033 A1**
(43) Date of publication of application: **28.03.2001**
(21) Application number: 00120767.9
(22) Date of filing: 22.09.2000
(51) Int. Cl.: C23C 14/34, H01J 37/34

(54) **Extended life sputter targets**

(30) Priority: 23.09.1999 US 401936
(71) Applicant: PRAXAIR TECHNOLOGY, INC., Danbury, CT 06810-5113 (US)
(72) Inventor: Strauss, David, Glen Rock, NJ 07452 (US); Blanchet, Jean Pierre, 31810 Venerque (FR)
(74) Representative: Schwan, Gerhard, Dipl.-Ing.

(57) **Abstract**

A sputter target is provided having an extended useful life for depositing thin films on integrated circuits. A planar target is formed having annular stepped regions on the sputter surface corresponding in location to the target raceways in which erosion grooves will form during sputtering. These rings of increased thickness provide additional material for sputtering without negatively affecting thin film properties. The targets of the present invention may be sputtered for an extended period of time before replacement is needed, thereby increasing deposition productivity.

## Description

### Field of the Invention

This invention relates to sputter targets having a long useful life and method of manufacturing said targets.

### Background of the Invention

Sputtering refers to a process which involves the coating of a semiconductor wafer or other substrate mounted within a processing chamber, which wafer is biased electrically with respect to a spatially opposed sputter target made of the material to be sputtered. An inert gas is introduced into the chamber at low temperature and an electric field is applied to ionize the gas. Ions from the gas bombard the target and dislodge atoms from the target which are subsequently deposited as a thin film onto the wafer or other substrate to be coated with the target material.

In addition to the use of an electrical field, increasing sputtering rates have been achieved by the concurrent use of an arch-shaped magnetic field that is superimposed over the electrical field and formed in a closed loop configuration over the surface of the target. These methods are known as magnetron sputtering methods. The arch-shaped magnetic field traps electrons in an annular region adjacent to the target surface, thereby increasing the number of electron-gas atom collisions in the area to produce an increase in the number of positive gas ions in the region that strike the target to dislodge the target material. Accordingly, the target material becomes eroded in a generally annular section of the target face, known as the target raceway. The eroded portion of the target is often referred to as the erosion groove. Depending on the arrangement of the magnets that create the magnetic field, one or more annular erosion grooves may form in the sputter target.

As the erosion grooves deepen, the properties of the deposited thin film may worsen. For example, film thickness or resistance uniformity may be sacrificed as a target approaches the end of its useful life. Thus, a target is typically sputtered only until (a) the sputtering performance decreases to an unacceptable level, such as decreased thin film uniformity; (b) the target thickness has been reduced such that there is a high possibility of punching through to the backing plate material; or (c) the raceway regions have been reduced to the point where the target no longer has the mechanical stability to support itself. Any of these failures could lead to catastrophic problems in wafer contamination and loss, and potentially complete defilement of the sputtering equipment. To avoid such failures, the targets are routinely changed with conservative lifetimes, thus resulting in frequent disruption of production. Furthermore, it may be appreciated that only the portion of target material in the target raceway region is being consumed before the target must be replaced. The remainder of material, mostly that which falls outside the raceway region, is either wasted or must be recycled.

There is thus a need to increase the amount of material available for sputtering to increase a target's useful life, without increasing the amount of material waste, and without negatively affecting sputtering performance.

### Summary of the Invention

The present invention provides a sputter target for thin film deposition having an extended useful life. To this end, and in accordance with the principles of the present invention, one or more rings of increased thickness are formed on the sputter surface corresponding in location to the raceway region where erosion grooves will form during sputtering. Advantageously, these rings are stepped regions having top planar surfaces and opposing sides angled non-perpendicularly relative to the top planar surface. In a preferred embodiment of the present invention, the rings have a thickness of about 2-6 mm, preferably about 4 mm, and a width of about 20-60 mm. In a target configuration in which an inner and an outer erosion groove will form, two rings of increased thickness are preferably formed, preferably with the outer ring being wider than the inner ring. To manufacture an extended life sputter target of the present invention, a target blank is formed and the top surface thereof is machined away to form the annular stepped regions. The stepped regions located where erosion grooves will form provide increased material for sputtering without increasing material waste and without negatively affecting film properties.

These and other objects and advantages of the present invention shall become more apparent from the accompanying drawings and description thereof.

### Brief Description of the Drawings

The accompanying drawings, which are incorporated in and constitute a part of this specification, illustrate an embodiment of the invention and, together with a general description of the invention given above, and the detailed description given below, serve to explain the principles of the invention.
Figure 1 is a top plan view of a sputter target of the present invention having an inner ring and an outer ring of increased thickness; and
Figure 2 is a cross-sectional view of the sputter target of Figure 1, showing in phantom the target blank from which it was machined.

### Detailed Description

The lifetime of a metallic sputter target is increased by increasing the material available for deposition by selectively increasing the thickness of the target in the areas of highest erosion. The change in thickness is accomplished without degrading any film property, such as film thickness or resistance uniformity. Visually, the target appears to have rings of increased material thickness on the target surface. The rings cover the raceway regions and are greater in width than the erosion grooves that would form in that region during sputtering in the absence of the additional material.

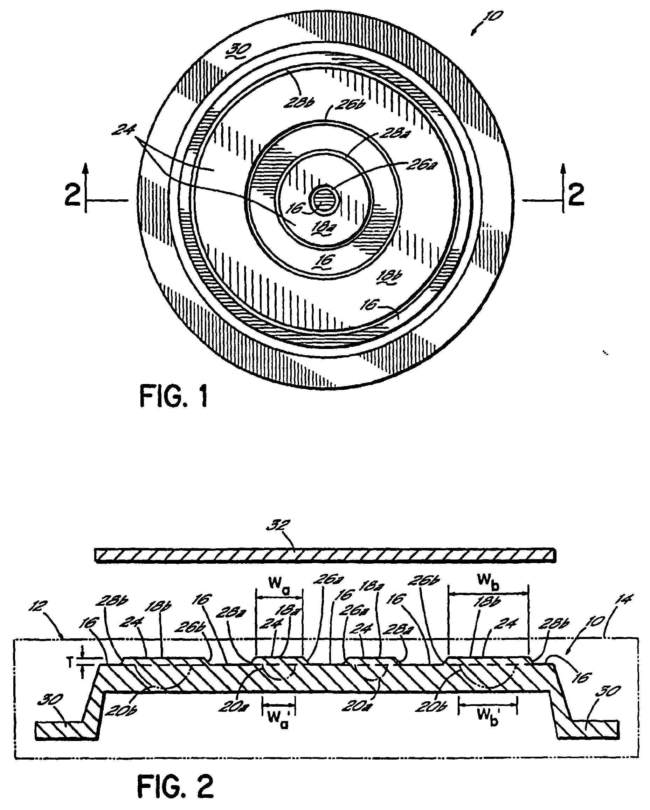

Typically, planar sputter targets are machined from a target blank to have a flat, smooth surface and to form the flanges that allow the target to be secured in the deposition chamber. Machining may be performed with a mechanical lathe or by any other suitable cutting tool. Certain parameters, such as the diameter of the target and the thickness of the flange are set by the customer to comply with their deposition equipment. In the target of the present invention, as shown in top planar view in Figure 1 and cross-sectional view in Figure 2, these parameters need not be changed to implement the principles of the present invention. A sputter target 10 is machined from a target blank 12, shown in phantom. The target blank 12 may be formed by any known process such as casting, forging or pressing. The top surface 14 of the target blank 12 is machined down to form a planar surface 16 with annular stepped regions 18a, 18b in the form of rings. The stepped regions 18a, 18b are formed to correspond to the locations where annular erosion grooves 20a, 20b, shown in phantom, would form during sputtering in the absence of the stepped regions. In the particular embodiment shown in Figures 1 and 2, the magnetic field produced (not shown) would result in the formation of a narrow inner erosion groove 20a and a wide outer erosion groove 20b. Thus, in accordance with the principles of the present invention, an inner stepped region 18a is formed over the region where inner erosion groove 20a will form such that the width Wₐ of the ring (measured in the radial direction at the top surface 24 of the ring) is greater than the width Wₐ' of the erosion groove 20a (measured in the radial direction at surface 16). Likewise, an outer stepped region 18b is formed over the region where outer erosion groove 20b will form such that the width W_{b} of the ring (measured at top surface 24) is greater than the width W_{b}' of the erosion groove 20b (measured at surface 16). Although the widths Wₐ, W_{b} of the rings are dependent upon the widths Wₐ', W_{b}' of the erosion grooves, the widths of the rings will typically be in the range of about 20-60 mm. In one embodiment of the present invention, inner stepped region 18a has a width of about 30 mm, while outer stepped region 18b has a width of about 50 mm.

It is to be understood that while the present discussion focuses upon an embodiment in which two erosion grooves form, the magnetic fields may be arranged so as to produce a single erosion groove or any number of multiple grooves. In accordance with the principles of the present invention, target life may be increased by the formation of a stepped region over any target raceway to provide additional material for eroding. In the two erosion groove embodiment, for example, a stepped region may be formed only over the outer groove, only over the inner groove, or over both.

Each stepped region 18a and 18b is preferably formed to have a thickness T of about 2-6 mm, and preferably about 4 mm. In other words, stepped regions 18a and 18b extend about 2-6 mm above planar surfaces 16 to provide additional target material in regions in which the majority of sputtering will occur. The sputtering of the material in these regions of increased thickness provides good film properties for an extended period of time, thus decreasing the frequency with which the targets need replacement.

Each stepped region 18a and 18b is preferably formed with a top planar surface 24 and opposing side surfaces 26a, 26b, 28a and 28b that are angled non-perpendicularly relative to the top planar surface 24. The angle preferably is in the range of about 20°-60°. By way of example only, and not limitation, inner stepped region 18a may be formed with each of opposing sides 26a, 28a angled 45° toward each other, while outer stepped region 18b is formed with opposing side 26b angled 45° inwardly and opposing side 28b angled 30° inwardly. In such a configuration, the stepped regions have a shape that minimizes the amount of unusable target material left after the target has reached is useful life.

From the target blank 12, a flange 30 is also formed in the target 10 for securing the target in the deposition chamber (not shown). The flange 30 may be of any known or future-developed configuration. The sputter target may be bonded to a backing plate (not shown), if desired, to form a sputter target/backing plate assembly. Target 10 may then be sputtered to deposit a thin film layer on wafer 32 placed in opposing relation to target 10.

The extended-life sputter targets of the present invention may be comprised of any material used as a metallizing layer on an integrated circuit. The present invention has been found particularly useful for pure or alloyed aluminum, copper, titanium, tantalum, cobalt or precious metal targets, the precious metals being commonly known as platinum, palladium, ruthenium, rhodium, osmium and iridium.

By way of example, and not limitation, a sputter target of the present invention may be machined to have a planar sputter surface 16 of about 323 mm diameter with 4 mm thick, 30 mm wide inner and outer annular stepped regions on a 19.6 mm thick target. In use, magnetron sputtering was conducted in argon gas at 10.93 kW with a chamber pressure of 2mT. An aluminum/0.5 wt.% copper target having a 323 mm diameter and 19.6 mm thickness without the thick rings according to the present invention may be sputtered for about 850 kW-hrs, while an aluminum/0.5 wt.% copper target of the present invention having the same dimensions but with 4 mm thick, 30 mm wide inner and outer stepped regions may be sputtered for up to about 1500 kW-hrs. This longer sputtering time is achieved without degradation of any film property. Furthermore, deeper erosion grooves may be observed where stepped regions were used. Thus, the targets of the present invention increase sputtering productivity by providing more material in the areas of highest erosion while maintaining the integrity of the thin films deposited on the wafers; and moreover, the targets of the present invention do not increase target material waste.

While the present invention has been illustrated by the description of an embodiment thereof, and while the embodiment has been described in considerable detail, it is not intended to restrict or in any way limit the scope of the appended claims to such detail. Additional advantages and modifications will readily appear to those skilled in the art. The invention in its broader aspects is therefore not limited to the specific details, representative apparatus and method and illustrative examples shown and described. Accordingly, departures may be made from such details without departing from the scope or spirit of applicants' general inventive concept.

## Claims

1. A sputter target for depositing uniform thin films, the sputter target comprising a planar sputter surface and an inner and an outer annular ring for extending target life during magnetron sputtering, the inner and outer rings having a planar top surface and an increased thickness in comparison to the planar sputter surface, the planar sputter surface extending within the inner ring, between the inner and the outer annular rings and beyond the outer ring.

2. The sputter target of claim 1, wherein the outer ring is wider in a radial direction than the inner ring.

3. The sputter target of claim 1, wherein the inner and outer rings have a width measured in a radial direction of about 20-60 mm.

4. The sputter target of claim 1, wherein the sputter target is comprised of a material selected from the group consisting of: aluminum, copper, titanium, tantalum, cobalt, platinum, palladium, ruthenium, rhodium, osmium and iridium and alloys thereof.

5. The sputter target of claim 1, wherein the inner and outer rings have a thickness of about 2-6 mm measured in a direction perpendicular to the plane of the target sputter surface.

6. The sputter target of claim 1, wherein the inner and outer rings have a thickness of about 4 mm measured in a direction perpendicular to the plane of the target sputter surface.

7. The sputter target of claim 1, wherein the inner and outer surfaces have opposing side surfaces non-perpendicularly disposed to the top planar surface.

8. The sputter target of claim 1, wherein the inner and outer rings have a thickness of about 2-6 mm measured in a direction perpendicular to the plane of the target sputter surface and a width measured in a radial direction of about 20-60 mm.

9. A method for increasing the useful life of a sputter target for use depositing of thin films, comprising the steps of:
forming a sputter target blank having a top surface; and
machining away the top surface of the blank to form a planar sputter surface and an inner and an outer annular ring to extend target life during magnetron sputtering, the inner and outer rings having a planar top surface and an increased thickness in comparison to the planar sputter surface, the planar sputter surface extending within the inner ring, between the inner and the outer annular rings and beyond the outer ring.

10. The method of claim 9, including the additional step of machining opposing side surfaces of the inner and outer rings at an angle of about 20°-60° relative to the top planar surfaces thereof.
